# EUROPEAN PATENT APPLICATION

(11) **EP 2 373 141 A1**
(43) Date of publication of application: **05.10.2011**
(21) Application number: 11158881.0
(22) Date of filing: 18.03.2011
(51) Int. Cl.: H05K 7/20, F24F 11/00, F24F 13/075

(54) **Air conditioning system and air conditioning control method**

(30) Priority: 02.04.2010 JP 2010086529
(71) Applicant: FUJITSU LIMITED, Kawasaki-shi, Kanagawa 211-8588 (JP)
(72) Inventor: Ohba, Yuji, Kanagawa 211-8588 (JP); Ishimine, Junichi, Kanagawa 211-8588 (JP); Nagamatsu, Ikuro, Kanagawa 211-8588 (JP)
(74) Representative: Lewin, David Nicholas

(57) **Abstract**

An air conditioning system disclosed in the present application includes an air conditioner configured to send cooling air to a space installed with racks for mounting one or more electronic devices, an opening panel configured to supply into the space the cooling air sent by the air conditioner, and an opening control unit configured to control the opening panel to shift, every predetermined time, the region supplied with the cooling air.

## Description

### FIELD

This application relates to an air conditioning system and an air conditioning control method.

### BACKGROUND

In the past, data centers have been used which supply cool air to server racks mounted with IT (Information Technology) devices from under floor part through panels. In this type of data centers, the indispensable air volume of cooling air needed for cooling the server racks has been increasing along with an increase in heat generation density of the IT devices mounted on the racks. Consequently, the air volume of the cooling air supplied by an air conditioner runs short, and there arises an issue of occurrence of a hot spot caused by the inflow of exhaust air from the IT devices.

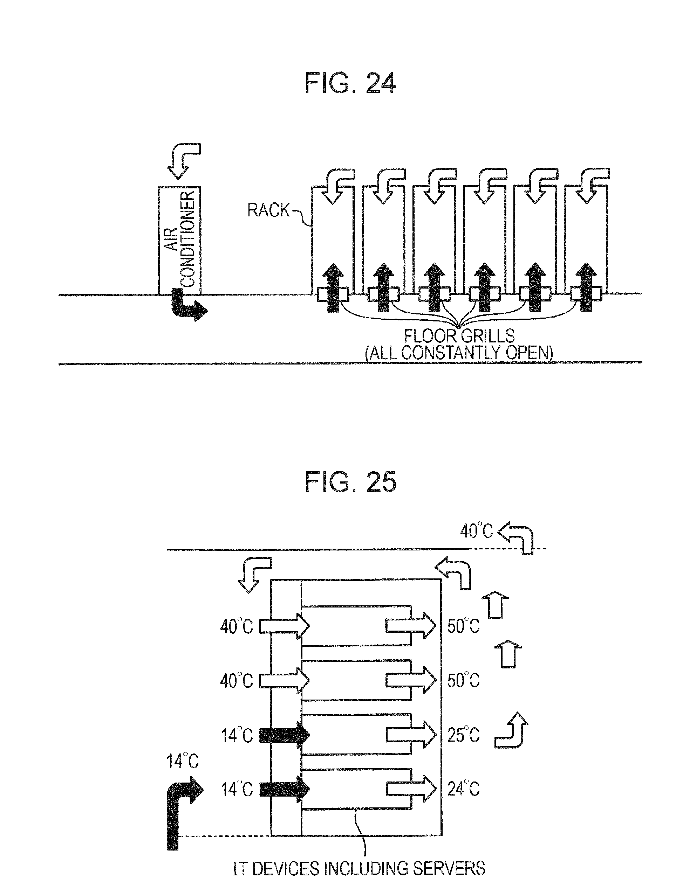

For example, if the air volume of the cooling air supplied by the air conditioner runs short, the inflow of exhaust air from the IT devices causes the hot spot. That is, the hot spot in a data center is caused by the shortage of the cooling air at a relatively low temperature supplied from the air conditioner, as compared with the air volume used by the IT devices for cooling purpose. For example, as illustrated in FIG. 24, if the air volume of the cooling air supplied to a rack (indicated by a black arrow in the example of FIG. 24) runs short, hot exhaust air at a relatively high temperature from the rack or an adjacent rack (indicated by a white arrow in the example of FIG. 24) is used to compensate for the shortage of the cooling air. Consequently, the intake air temperature of the rack rises.

Further, if the air volume of the air blown out of the air conditioner runs short, the cooling air is supplied to the IT devices mounted on lower portions of the racks, but is not supplied to the IT devices mounted on upper portions of the racks. As a result, the hot spot is generated in the upper portions of the racks.

Herein, specific description is made with reference to the example of FIG. 25. FIG. 25 illustrates an example in which the temperature of the cooling air supplied by the air conditioner is 14°C, and in which the air volume of the supplied cooling air is half the indispensable air volume needed for cooling the racks. As illustrated in FIG. 25, the IT devices mounted on lower portions of the racks take in the cooling air at 14°C supplied through opening panels, and discharge hot exhaust air at 24°C to 25°C.

Meanwhile, in the IT devices mounted on upper portions of the racks, the recirculation of exhaust air is caused by the shortage of the cooling air. Thus, the IT devices take in hot exhaust air at 40°C and discharge hot exhaust air at 50°C. In this manner, the difference in temperature arises between the IT devices on upper shelves and the IT devices on lower shelves, and the recirculation of exhaust air due to the shortage of the cooling air occurs in the electronic devices mounted on the upper shelves. Thereby, the hot spot is generated.

In view of this, the layout of the racks or the position of floor grills is changed as a method for preventing such a hot spot. For example, to increase the supply of the cooling air to the site of occurrence of the hot spot, the number, the position, or the opening ratio of the arranged floor grills is adjusted, or the layout of the racks is adjusted by reference to the distribution of the heat generation amount of the racks. Thereby, the hot spot attributed to the localized shortage of the air volume is prevented.

Further, the provision of an increased number of air conditioners to increase the air volume of the cooling air is known as a method for preventing the hot spot. For example, an increased number of air conditioners are provided in the vicinity of the site of occurrence of the hot spot, to thereby increase the air volume of the cooling air in the vicinity of the site of occurrence of the hot spot and prevent the hot spot.

Related art includes Japanese Laid-open Patent Publication Nos. 2004-184070, 2004-248066, 2005-260148, 2006-526205, 2008-502082, 2006-504919, 2007-505285, 2006-114669, and 2004-263925.

The above-described method of changing the layout of the racks or the position of the floor grills, however, is unable to eliminate the hot spot, if the air volume of the supplied cooling air is less than the indispensable air volume needed for cooling the racks. Further, the above-described method of providing an increased number of air conditioners increases the power consumption needed for air-conditioning, and thus is unable to efficiently cool the racks.

### SUMMARY

A technique disclosed herein has been made in view of the above, and an object of thereof is to, even if there is a rack in which the air volume of the supplied cooling air is less than the necessary air volume, efficiently cool the rack and eliminate the hot spot.

An air conditioning system disclosed in the present application includes an air conditioner configured to send cooling air to a space installed with racks mounted with electronic devices, an opening panel configured to supply into the space the cooling air sent by the air conditioner, and an opening control unit configured to control the opening panel to shift, every predetermined time, the region supplied with the cooling air.

### BRIEF DESCRIPTION OF DRAWINGS

FIG. 1 is a block diagram illustrating a configuration of an air conditioning system according to a first embodiment;

FIG. 2 is a top view of an air conditioning system according to a second embodiment;

FIG. 3 is a side view of the air conditioning system according to the second embodiment;

FIG. 4 is a diagram illustrating a structure example of a floor grill;

FIG. 5 is a diagram illustrating a connection example of an opening control unit connected to floor grills;

FIG. 6 is a diagram illustrating an example of a floor grill opened and closed by rotary louvers;

FIG. 7 is a diagram illustrating changes in rack intake air temperature and rack exhaust air temperature;

FIG. 8 is a diagram illustrating an installation example of anemometers;

FIG. 9 is a diagram for explaining cooling air supplied when the floor grills on the left half side are opened;

FIG. 10 is a diagram for explaining cooling air supplied when the floor grills on the right half side are opened;

FIG. 11 is a diagram for explaining a grill opening and closing unit;

FIGs. 12A to 12H are diagrams for explaining a grill opening and closing position changing process;

FIG. 13 is a diagram illustrating intake air temperatures of IT devices mounted on a rack running short of the air volume in an existing air conditioning system;

FIG. 14 is a diagram illustrating intake air temperatures of IT devices mounted on a rack running short of the air volume in the air conditioning system according to the first embodiment;

FIG. 15 is a flowchart for explaining a procedure of the grill opening and closing position changing process performed in the air conditioning system according to the second embodiment;

FIG. 16 is a diagram for explaining cooling air supplied when the blow-off direction is to the left;

FIG. 17 is a diagram for explaining cooling air supplied when the blow-off direction is to the right;

FIG. 18 is a diagram for explaining cooling air supplied when the floor grills are constantly open;

FIG. 19 is a diagram for explaining cooling air supplied when the blow-off direction is to the left;

FIG. 20 is a diagram for explaining cooling air supplied when the floor grills are alternately opened and closed;

FIG. 21 is a diagram for explaining cooling air supplied when the floor grills are constantly open;

FIG. 22 is a diagram for explaining cooling air supplied when the floor grills on the left half side are opened;

FIG. 23 is a diagram for explaining cooling air supplied when the floor grills on the right half side are opened;

FIG. 24 is a diagram for explaining airflow in an existing air conditioning system; and

FIG. 25 is a diagram for explaining airflow in an existing air conditioning system.

### DESCRIPTION OF EMBODIMENTS

With reference to the accompanying drawings, detailed description is made below of embodiments of an air conditioning system and an air conditioning control method according to an embodiment of the present application.

First Embodiment

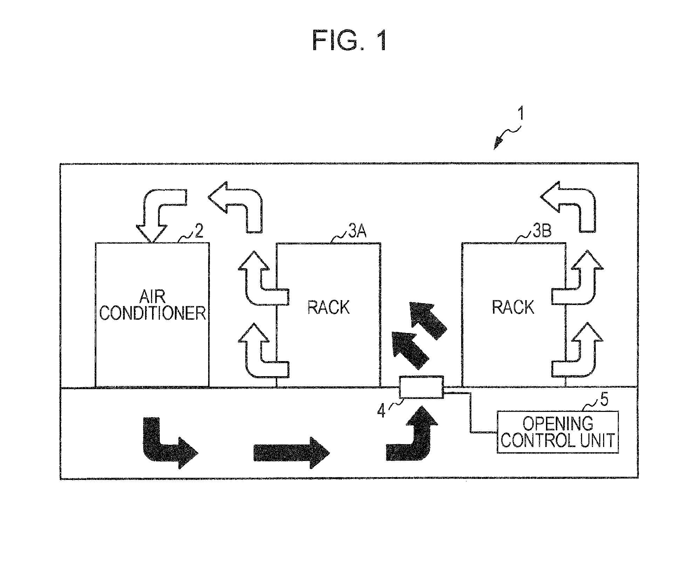

With reference to FIG. 1, a configuration of an air conditioning system according to a first embodiment is first described. FIG. 1 is a diagram for explaining a configuration of the air conditioning system according to the first embodiment. In the drawings described below, a black arrow indicates the flow of cooling air, and a white arrow indicates the flow of hot exhaust air.

As illustrated in FIG. 1, the air conditioning system 1 according to the first embodiment includes an air conditioner 2, racks 3A and 3B, an opening panel 4, and an opening control unit 5. The air conditioner 2 sends cooling air to a space installed with the racks 3A and 3B. The racks 3A and 3B are mounted with electronic devices, each of which takes in air from a predetermined surface thereof and discharges air from a surface thereof opposite to the predetermined surface.

The opening panel 4 supplies into the space the cooling air sent by the air conditioner 2. The opening control unit 5 controls the opening panel 4 to shift, every predetermined time, the position of a region in the space supplied with the cooling air.

For example, as exemplified in FIG. 1, the opening control unit 5 controls the opening panel 4 such that the cooling air is supplied to the region installed with the rack 3A. Then, after the lapse of a predetermined time, the opening control unit 5 controls the opening panel 4 such that the cooling air is supplied to the region installed with the rack 3B. Thereafter, the opening control unit 5 alternates, every predetermined time, the supply of the cooling air between the racks 3A and 3B.

The position of the region supplied with the cooling air is thus changed every specified time, to thereby equalize the rack intake air temperatures at respective locations, without fixing the site of occurrence of a hot spot. It is thereby possible to eliminate the hot spot even with small air volume. Consequently, the air conditioning system 1 according to the first embodiment efficiently cools the racks 3A and 3B and eliminates the hot spot, even if the air volume of the supplied cooling air is less than the indispensable air volume needed for cooling the racks 3A and 3B.

Second Embodiment

In the following embodiment, a configuration and a process flow of an air conditioning system 10 according to a second embodiment is sequentially described, and effects of the second embodiment is finally described.

Configuration of Air Conditioning System

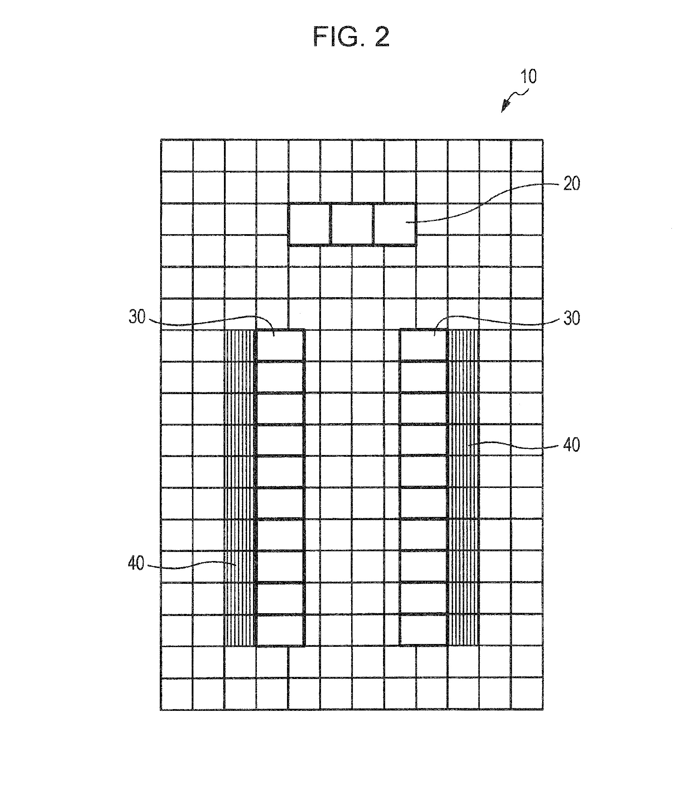

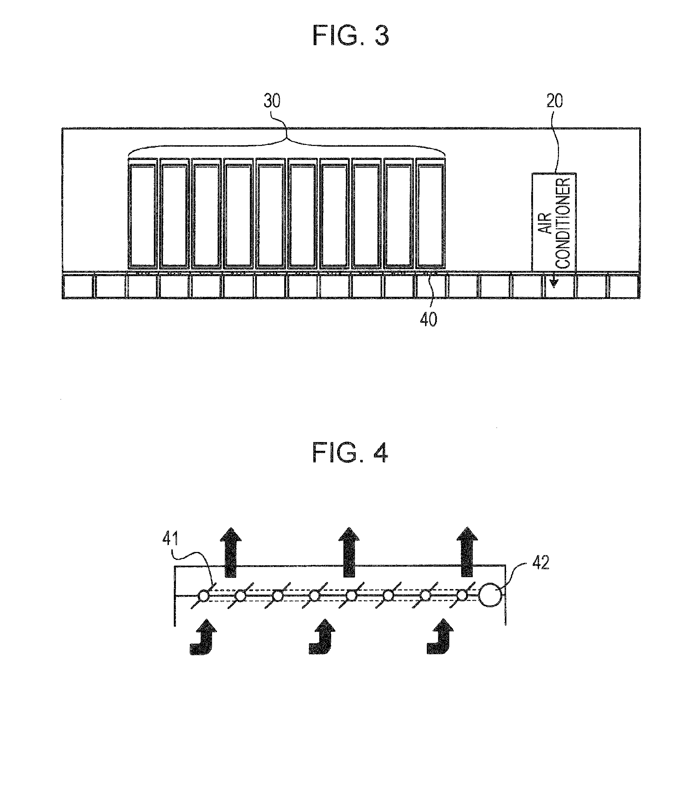

Subsequently, a configuration of the air conditioning system 10 is described with reference to FIGs. 2 and 3. FIG. 2 is a top view of the air conditioning system 10 according to the second embodiment. FIG. 3 is a side view of the air conditioning system 10 according to the second embodiment.

As illustrated in FIG. 2, the air conditioning system 10 includes an air conditioner 20, racks 30, and floor grills 40. The air conditioner 20 blows cooling air to the racks 30, and takes in hot exhaust air discharged by the racks 30. Specifically, the air conditioner 20 blows cooling air to thereby supply the cooling air to the racks 30 installed on the floor. The racks 30, which are mounted with IT devices, take in the cooling air supplied by the air conditioner 20, and discharge the hot exhaust air.

Further, as illustrated in FIG. 3, the air conditioning system 10 has a double-floor configuration including a raised-floor level and a bottom-floor level. The air conditioner 20 sends the cooling air to the bottom-floor level to supply, through the floor grills 40, the cooling air to the racks 30 installed on the raised-floor level.

The floor grills 40 are opening panels installed on floor tiles in the vicinity of the racks 30 to supply the cooling air sent to the floor. Herein, a structure of each of the floor grills 40 is described with reference to FIG. 4. FIG. 4 is a diagram illustrating a structure example of the floor grill 40. As illustrated in FIG. 4, the floor grill 40 includes louvers 41 and an opening and closing motor 42.

The louvers 41 are provided in the floor grill 40, and rotate therein. The opening and closing motor 42 rotates a belt provided to respective rotary shafts of the louvers 41, to thereby rotate the louvers 41. For example, the opening and closing motor 42 operates at a rotation rate, at which the louvers 41 make one rotation at the time interval set by an opening control unit 50 described later.

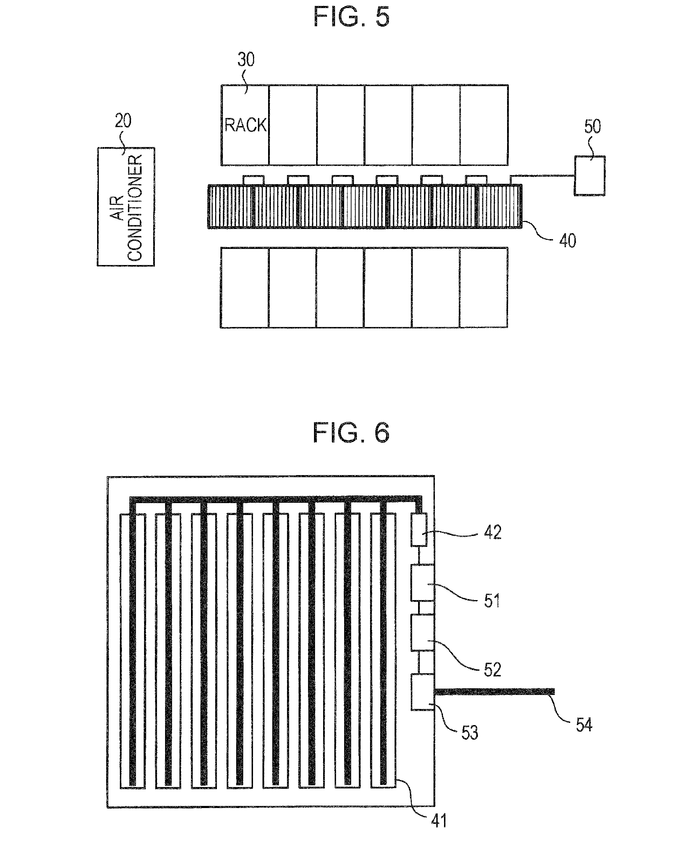

Herein, with reference to FIGs. 5 and 6, description is made of the opening control unit 50 which controls the opening and closing of the floor grills 40. FIG. 5 is a diagram illustrating a connection example of the opening control unit 50 connected to the floor grills 40. FIG. 6 is a diagram illustrating an example of the floor grill 40 opened and closed by the rotary louvers 41. As exemplified in FIG. 5, the floor grills 40 are connected to the opening control unit 50 which controls the opening and closing of each of the floor grills 40.

The opening control unit 50 controls the opening and closing of the floor grills 40 to shift, every predetermined time, the position of the region supplied with the cooling air. As illustrated in FIG. 6, the opening control unit 50 includes a motor control unit 51, an opening and closing time setting and display unit 52, an I/O (Input/Output) device 53, and a network cable 54, and is connected to a not-illustrated external control unit via the network cable 54.

The motor control unit 51 control the opening and closing motor 42 to change, at every predetermined time interval, the opening and closing position of the floor grills 40. The motor control unit 51 has a clock function provided therein to synchronize the opening and closing timing among the floor grills 40, and synchronizes the opening and closing among the floor grills 40 at a set time interval. A grill opening and closing position changing process by the motor control unit 51 is described in detail later.

The opening and closing time setting and display unit 52 receives the opening and closing time interval input from the I/O device 53, and displays the received opening and closing time interval. Upon receipt of an opening and closing timing synchronization signal or an opening and closing pattern input from the external control unit via the network cable 54, the I/O device 53 notifies the opening and closing time setting and display unit 52 of the opening and closing time interval.

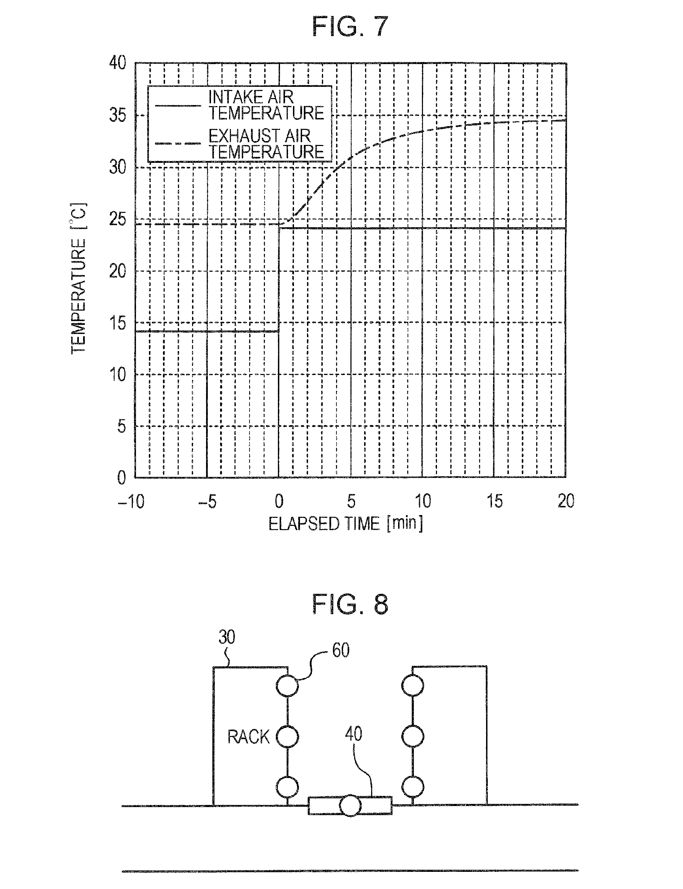

Herein, the opening and closing time interval is described with reference to FIG. 7. FIG. 7 is a diagram illustrating changes in rack intake air temperature and rack exhaust air temperature. The opening and closing time interval of the floor grills 40 can be arbitrarily set. It is, however, preferred to set the opening and closing time interval to be less than an exhaust air temperature rise time, preferably approximately a few minutes to approximately thirty minutes. That is, if the opening and closing time interval is excessively short, the cool air blown out of the floor grills 40 fails to reach upper portions of the racks 30, and the phenomenon of exchange of rack intake air temperatures does not take place.

Further, as illustrated in FIG. 7, even if the intake air temperature of an IT device rises, the exhaust air temperature thereof does not immediately rise owing to the heat capacity thereof, and starts to gradually rise after a certain time lag. In general, it takes approximately a few minutes to approximately thirty minutes from a rise in intake air temperature to a rise in exhaust air temperature. If the opening and closing time interval is set to a time less than the time taken for the exhaust air temperature of an electronic device to rise to a predetermined temperature, therefore, it is possible to keep the maximum intake air temperature of an air intake surface of a rack to a low value. For example, the opening and closing time interval is set to "four minutes," which is a time less than the time taken for the exhaust air temperature of an electronic device to rise to "30°C."

Subsequently, description is made of anemometers 60 installed to the racks 30 and the floor grills 40. FIG. 8 is a diagram illustrating an installation example of the anemometers 60. As illustrated in FIG. 8, the anemometers 60 are installed to the racks 30 and the floor grills 40 to measure the respective wind velocities at the locations installed therewith and notify the motor control unit 51 of the measured wind velocities.

Herein, the grill opening and closing position changing process by the motor control unit 51 is specifically described. The motor control unit 51 acquires, from the anemometers 60 installed to the racks 30 and the floor grills 40, the average rack wind velocity measurement value and the average grill wind velocity measurement value. Then, with the use of the average rack wind velocity measurement value and the average grill wind velocity measurement value, the motor control unit 51 calculates the indispensable air volume and the supplied air volume.

Specifically, the motor control unit 51 calculates the indispensable air volume by multiplying the average rack wind velocity measurement value by the value of the rack air intake area. The motor control unit 51 further calculates the supplied air volume by multiplying the average grill wind velocity measurement value by the value of the grill air intake area. Then, the motor control unit 51 calculates an air volume ratio which corresponds to the value obtained by division of the supplied air volume by the indispensable air volume. Thereafter, the motor control unit 51 calculates an open grill number which corresponds to the value obtained by multiplication of the total grill number by the air volume ratio. Then, the motor control unit 51 calculates a closed grill number which corresponds to the value obtained by subtraction of the open grill number from the total grill number. Thereafter, the motor control unit 51 starts a timer set with the grill opening and closing time interval, and changes the grill opening and closing operation at every grill opening and closing time interval.

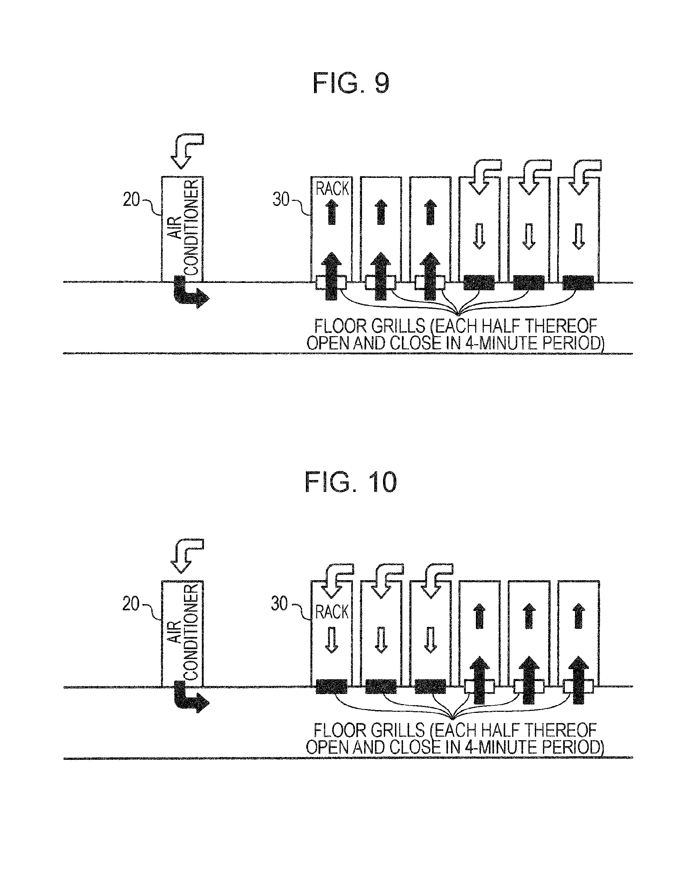

Herein, the grill opening and closing position changing process is described with reference to the example of FIGs. 9 and 10. In the example of FIGs. 9 and 10, description is made of an example in which the cooling air volume of the air conditioner 20 is 50% of the total indispensable air volume of the racks 30, the total floor grill number is "6," the open grill number is "3," the closed grill number is "3," and the grill opening and closing time interval is "four minutes." As illustrated in FIG. 9, the motor control unit 51 performs a control to open only three floor grills on the left half side and close three floor grills on the right half side. Then, after the lapse of four minutes, the motor control unit 51 performs a control to close the three floor grills on the left half side and open the three floor grills on the right half side, as illustrated in FIG. 10. Thereafter, the motor control unit 51 repeats the process of alternating, every four minutes, opening and closing of the left half and the right half of the floor grills.

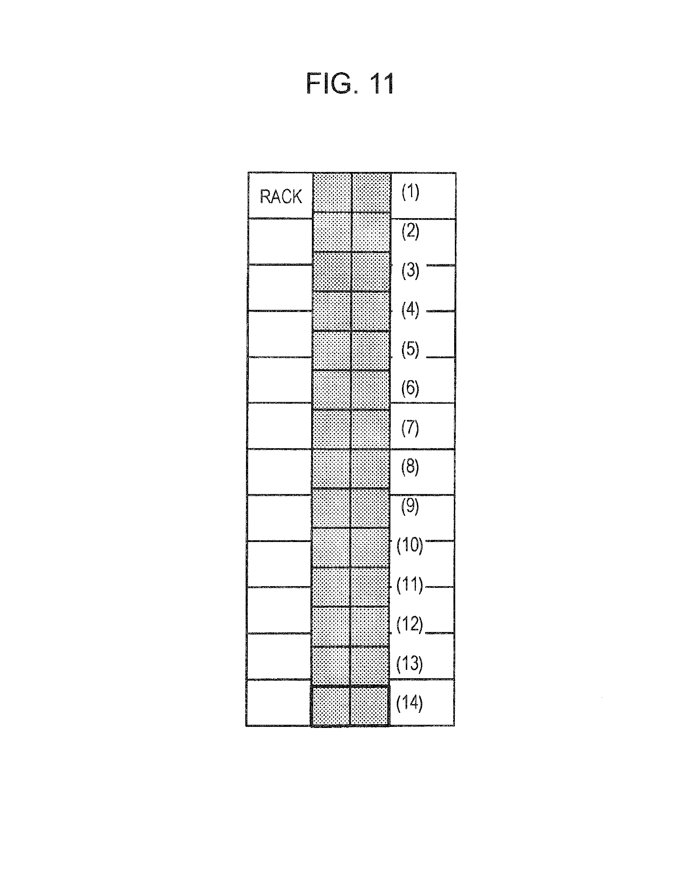

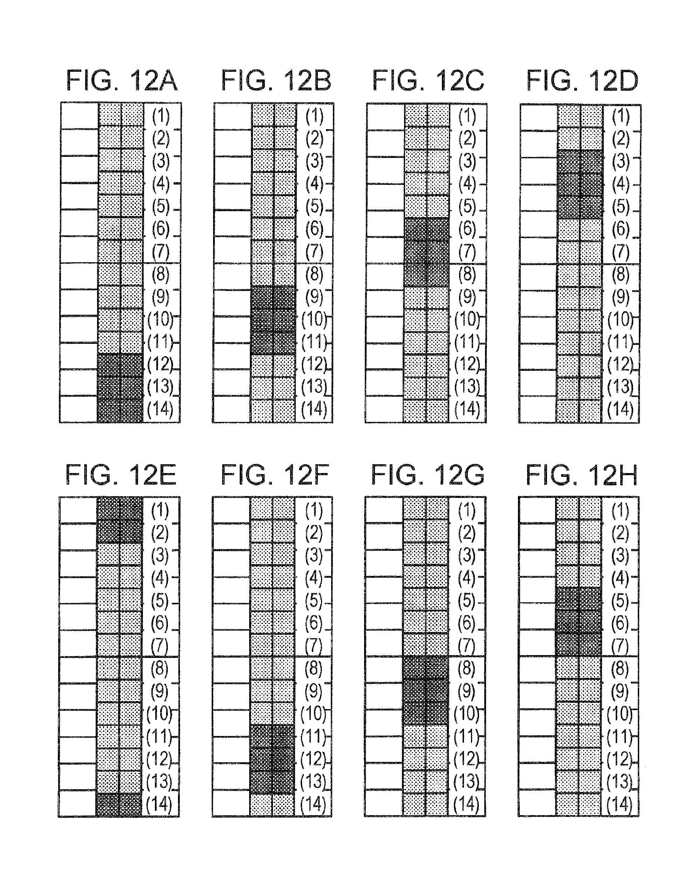

Herein, a method of determining the grills to be opened and the grills to be closed is described with reference to the examples of FIG. 11 and FIGs. 12A to 12H. In the examples of FIG. 11 and FIGs. 12A to 12H, there are two rack rows each including twelve racks, and twenty-eight square grills are installed on an aisle, across which the air intake surfaces of the racks face each other. Further, description is made of an example in which the grills are assigned with grill ID (identification) numbers "1" to "14," as illustrated in FIG. 11 and FIGs. 12A to 12H, and in which the total grill number is "14" and the open grill number is "11." In the following example, two grills encircled by a thick frame in FIG. 11 form a block corresponding to an opening and closing unit.

As an open grill ID number calculation process, the motor control unit 51 calculates, at every grill opening and closing time interval, the grill ID number "j" of the grill to be opened by using a calculation formula "MOD(11×i+1)/14≤j≤MOD(11×i+11)/14." Herein, "i" represents a value, the initial value of which is "0," and which is added with "1" at every lapse of the grill opening and closing time interval.

Then, the motor control unit 51 performs a control to open the grills corresponding to the calculated open grill ID numbers and close the grills corresponding to the other grill ID numbers. For example, as exemplified in FIG. 12A, if the motor control unit 51 performs the open grill ID number calculation process by using the above-described calculation formula with an i value of 0, the value j ranges from 1 to 11. Thus, the motor control unit 51 performs a control to open the grills corresponding to grill ID numbers "1" to "11" and close the grills corresponding to grill ID numbers "12" to "14."

Then, after the lapse of the grill opening and closing time interval, the motor control unit 51 adds "1" to the value i. The motor control unit 51 then performs the open grill ID number calculation process with an i value of 1, and performs a control to open the grills corresponding to grill ID numbers "12" to "14" and "1" to "8" and close the other grills (see FIG. 12B). Subsequently, after the lapse of the grill opening and closing time interval, the motor control unit 51 adds "1" to the value i. The motor control unit 51 then performs the open grill ID number calculation process with an i value of 2, and performs a control to open the grills corresponding to grill ID numbers "9" to "14" and "1" to "5" and close the other grills (see FIG. 12C).

Then, after the lapse of the grill opening and closing time interval, the motor control unit 51 adds "1" to the value i. The motor control unit 51 then performs the open grill ID number calculation process with an i value of 3, and performs a control to open the grills corresponding to grill ID numbers "6" to "14" and "1" and "2" and close the other grills (see FIG. 12D). Thereafter, the motor control unit 51 repeats the process of performing the open grill ID number calculation process, determining the ID numbers of grills to be opened, and controlling the opening and closing of the grills (see FIGs. 12E to 12H).

That is, the region supplied with the cooling air is changed every specified time, to thereby equalize the rack intake air temperatures at the respective locations, without fixing the site of occurrence of the hot spot. It is thereby possible to eliminate the hot spot even with small air volume. Consequently, the air conditioning system 10 according to the second embodiment efficiently cools the racks 30 and eliminates the hot spot.

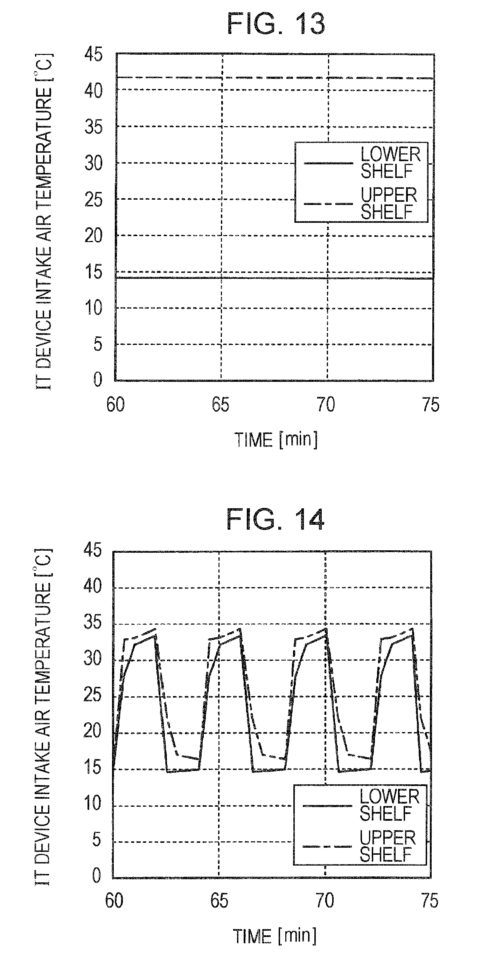

Herein, with reference to FIGS. 13 and 14, an existing air conditioning system and the air conditioning system 10 according to the second embodiment are compared with each other in terms of the respective intake air temperatures of an IT device mounted on an upper shelf of a rack and an IT device mounted on a lower shelf of the rack.

For example, in an existing air conditioning system, if the air volume of the cooling air supplied by the air conditioner runs short, the cooling air fails to reach an upper portion of the rack, and the intake air temperature of the IT device mounted on the upper shelf of the rack constantly exceeds 40°C, as illustrated in FIG. 13. Therefore, the site of occurrence of the hot spot is constantly fixed to the upper shelf of the rack. As a result, only the IT device mounted on the upper shelf of the rack constantly has a high intake air temperature, and a heat-induced failure, a reduction in life of the IT device, and so forth are caused.

Meanwhile, in the air conditioning system 10 according to the second embodiment, the region supplied with the cooling air is changed every specified time, as illustrated in FIG. 14. Thereby, the IT device mounted on the upper shelf of the rack and the IT device mounted on the lower shelf of the rack have a similar intake air temperature. In the air conditioning system 10 according to the second embodiment in the example of FIG. 14, the intake air temperature of a rack installed in the vicinity of an open floor grill is 14°C, and the intake air temperature of a rack installed in the vicinity of a closed floor grill is 35°C at the highest or lower. Therefore, the time-averaged average rack intake air temperature corresponds to 25°C in both the IT device mounted on the upper shelf of the rack and the IT device mounted on the lower shelf of the rack. Consequently, it is possible to prevent the heat-induced failure, the reduction in life of the IT device, and so forth, as compared with the existing air conditioning system.

Process by Opening Control Unit of Air Conditioning System

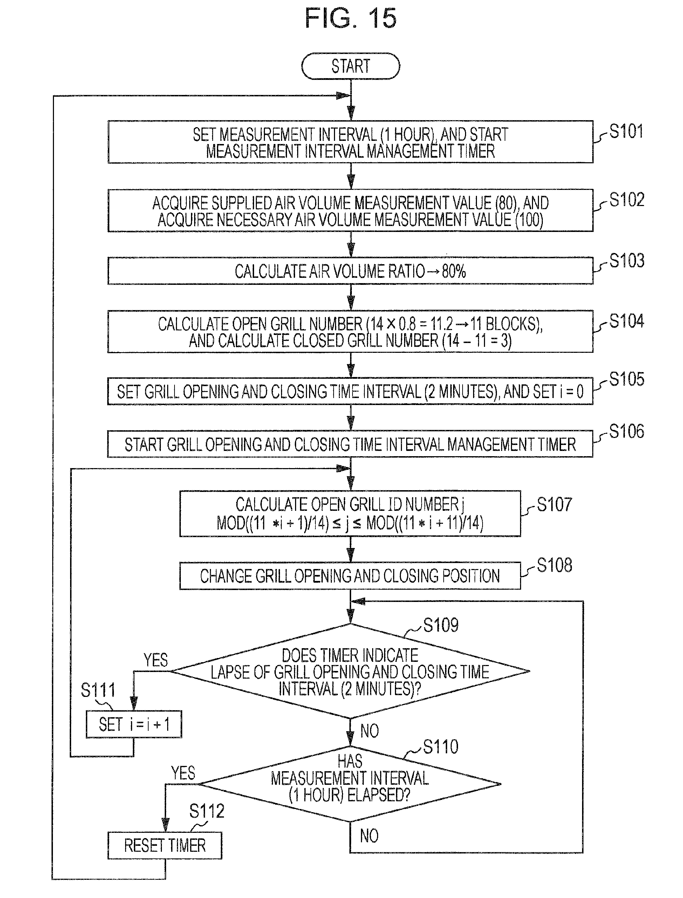

Subsequently, with reference to FIG. 15, description is made of the process performed by the opening control unit 50 of the air conditioning system 10 according to the second embodiment. FIG. 15 is a flowchart for explaining a procedure of the grill opening and closing position changing process performed in the air conditioning system 10 according to the second embodiment.

As illustrated in FIG. 15, after a measurement interval, which is the interval for measuring the supplied air volume and the indispensable air volume, is set and a measurement interval management timer starts (Step S101), the opening control unit 50 of the air conditioning system 10 acquires the supplied air volume measurement value and the indispensable air volume measurement value (Step S102). For example, it is assumed in the example of FIG. 15 that the measurement interval is set to one hour, and that the supplied air volume measurement value and the indispensable air volume measurement value are 80 m³/min and 100 m³/min, respectively.

Then, the opening control unit 50 calculates the air volume ratio by using the supplied air volume measurement value and the indispensable air volume measurement value (Step S103). For example, in the example of FIG. 15, the opening control unit 50 divides the supplied air volume measurement value of "80" by the indispensable air volume measurement value of "100" to obtain an air volume ratio of 80%.

Then, the opening control unit 50 calculates the open grill number and the closed grill number (Step S104). For example, in the example of FIG. 15, the opening control unit 50 multiplies a total grill number of "14" by the air volume ratio of "0.8" to obtain a value of "11.2," and rounds off the decimal number to obtain an open grill number of "11." Further, the opening control unit 50 subtracts the open grill number of "11" from the total grill number of "14" to obtain a closed grill number of "3."

Thereafter, the opening control unit 50 sets the grill opening and closing time interval (two minutes in the example of FIG. 15), and sets the value i to the initial value of 0 (Step S105). Then, the opening control unit 50 starts a grill opening and closing time interval management timer (Step S106), and calculates the open grill ID number (Step S107). For example, in the example of FIG. 15, the opening control unit 50 calculates, at every grill opening and closing time interval, the grill ID number "j" of the grill to be opened by using the calculation formula "MOD(111×i+1)/14≤j≤MOD(11×i+11)/14" as the open grill ID number calculation process.

Thereafter, the opening control unit 50 changes the grill opening and closing position (Step S108), and checks the grill opening and closing time interval management timer to determine whether or not two minutes, which corresponds to the grill opening and closing time interval, have elapsed (Step S109). If the opening control unit 50 consequently determines that two minutes have elapsed (YES at Step S109), the opening control unit 50 adds "1" to the value i (Step S111), and returns to the process of Step S107.

Meanwhile, if the opening control unit 50 determines that two minutes have not elapsed (NO at Step S109), the opening control unit 50 checks the measurement interval management timer to determine whether or not the measurement interval has exceeded one hour (Step S110). Then, if the opening control unit 50 checks the measurement interval management timer and determines that the measurement interval has not exceeded one hour (NO at Step S110), the opening control unit 50 returns to the process of Step S109. Meanwhile, if the opening control unit 50 checks the measurement interval management timer and determines that the measurement interval has exceeded one hour (YES at Step S110), the opening control unit 50 resets the timer (Step S112), and returns to Step S101.

Effects of Second Embodiment

As described above, the air conditioning system 10 includes the air conditioner 20 which sends the cooling air to the space installed with the racks 30 mounted with electronic devices, and the floor grills 40 which supply into the space the cooling air sent by the air conditioner 20. Further, the opening control unit 50 controls the floor grills 40 to shift, every predetermined time, the region supplied with the cooling air. As a result, the position of the region supplied with the cooling air is changed every specified time, to thereby equalize the rack intake air temperatures at the respective locations, without fixing the site of occurrence of the hot spot. It is thereby possible to eliminate the hot spot even with small air volume. Consequently, the air conditioning system 10 according to the second embodiment is capable of efficiently cooling the racks 30 and eliminating the hot spot.

Further, according to the second embodiment, the air conditioning system 10 controls the opening and closing of the floor grills 40 to shift, every predetermined time, the position of the region supplied with the cooling air. Consequently, the air conditioning system 10 is capable of changing, every specified time, the position of the region supplied with the cooling air in accordance with the opening and closing floor grills 40, and thereby efficiently cooling the racks 30 and eliminating the hot spot.

Further, according to the second embodiment, the air conditioning system 10 controls the floor grills 40 to shift, every time less than the time taken for the exhaust air temperature of the electronic devices to rise to a predetermined temperature, the position of the region supplied with the cooling air. It is therefore possible to keep the maximum intake air temperature of the air intake surface of each of the racks to a low value.

Third Embodiment

Meanwhile, in the above-described second embodiment, description has been made of an example of changing the opening and closing of the floor grills 40. The present embodiment, however, is not limited thereto, and the blow-off direction of the floor grills may be changed.

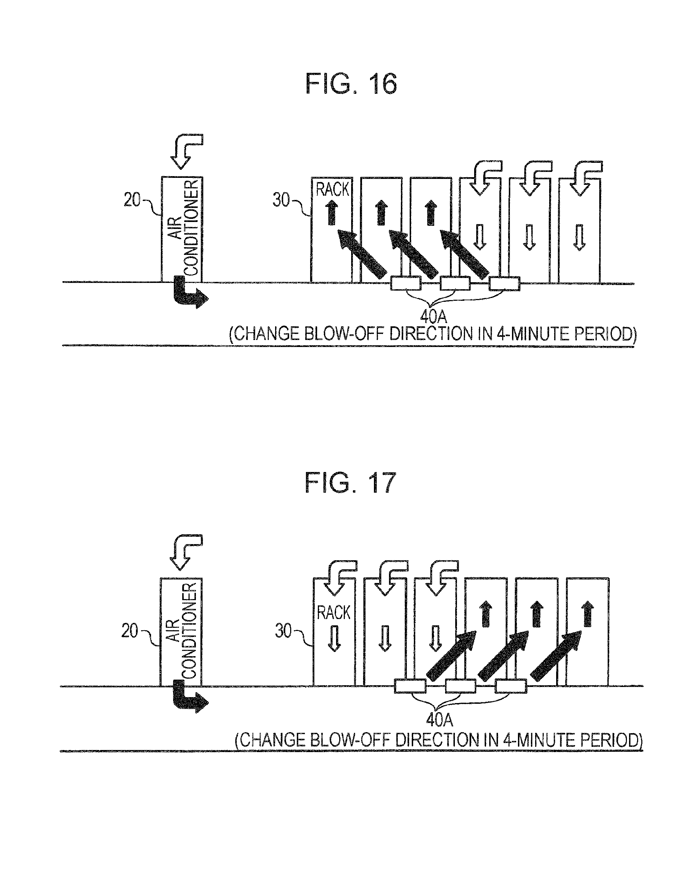

In the following third embodiment, therefore, an opening control process by an air conditioning system of the third embodiment is described, with reference to FIGs. 16 and 17, as an example of changing the blow-off direction of the floor grills. FIG. 16 is a diagram for explaining cooling air supplied when the blow-off direction is to the left. FIG. 17 is a diagram for explaining cooling air supplied when the blow-off direction is to the right.

As the example of FIGs. 16 and 17, description is made of an example in which the cooling air volume of the air conditioner 20 is 50% of the total indispensable air volume of the racks 30, and in which the total floor grill number is "3" and the grill opening and closing time interval is "four minutes." Although not illustrated in FIGs. 16 and 17, floor grills 40A are connected to an opening control unit 50A in a similar manner as in the second embodiment.

As illustrated in FIG. 16, the opening control unit 50A for controlling the floor grills 40A performs a control to blow the cooling air in the left direction. Then, after the lapse of four minutes, the opening control unit 50A performs a control to blow the cooling air in the right direction, as illustrated in FIG. 17. Thereafter, the opening control unit 50A repeats the process of changing, every four minutes, the blow-off direction of the floor grills 40A between the left and right directions.

As described above, according to the third embodiment, the blow-off direction of the floor grills 40A is controlled to shift, every predetermined time, the position of the region supplied with the cooling air. Consequently, it is possible to change, every specified time, the position of the region supplied with the cooling air in accordance with the blow-off direction of the floor grills 40A, and thereby to efficiently cool the racks 30 and eliminate the hot spot.

Fourth Embodiment

Further, in the above-described second embodiment, description has been made of an example in which the air conditioning system supplies the cooling air to the racks of one of the rows facing the aisle supplied with the cooling air. The present embodiment, however, is not limited thereto, and the cooling air may be alternately supplied to the racks of the left row and the racks of the right row facing the aisle supplied with the cooling air.

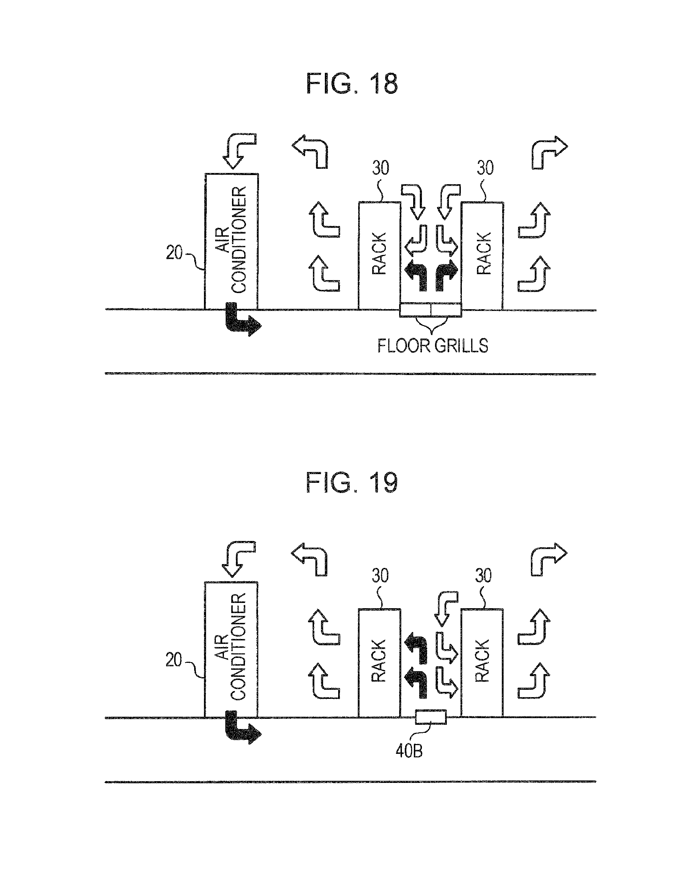

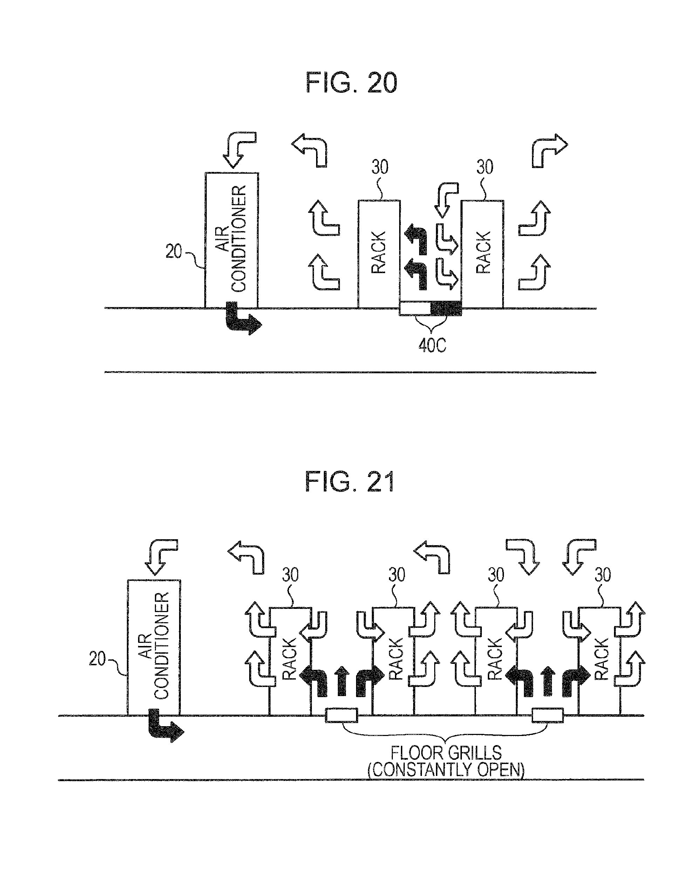

In the following fourth embodiment, therefore, an opening control process by an air conditioning system of the fourth embodiment is described, with reference to FIGs. 18 to 20, as an example of alternately supplying the cooling air to the racks of the left row and the racks of the right row facing the aisle supplied with the cooling air. FIG. 18 is a diagram for explaining cooling air supplied when the floor grills are constantly open. FIG. 19 is a diagram for explaining cooling air supplied when the blow-off direction is to the left. FIG. 20 is a diagram for explaining cooling air supplied when the floor grills are alternately opened and closed.

With reference to FIG. 18, description is first made of an existing air conditioning system which constantly opens all floor grills. It is assumed in the air conditioning system exemplified in FIG. 18 that the cooling air volume of the air conditioner 20 is 50% of the total indispensable air volume of the racks 30. The cooling air volume is insufficient with respect to the total indispensable air volume of the racks 30. As illustrated in FIG. 18, therefore, if the floor grills are constantly open, the cooling air fails to reach upper portions of the racks 30, and the IT devices mounted on upper shelves of the racks 30 constantly have a high intake air temperature.

The air conditioner 20 according to the fourth embodiment, therefore, alternately supplies the cooling air to the racks of the left row and the racks of the right row facing the aisle supplied with the cooling air, to thereby allow the cooling air to be supplied to the IT devices mounted on the upper shelves of the racks 30 and the IT devices mounted on the lower shelves of the racks 30. Herein, the air conditioner 20 according to the fourth embodiment is described with reference to FIGs. 19 and 20. As the examples of FIGs. 19 and 20, description is made of an example in which the cooling air volume of the air conditioner 20 is 50% of the total indispensable air volume of the racks 30 and the grill opening and closing time interval is "four minutes." Although not illustrated in FIGs. 19 and 20, floor grills 40B and 40C are connected to opening control units 50B and 50C, respectively, in a similar manner as in the second embodiment.

For example, as illustrated in FIG. 19, the opening control unit 50B for controlling the floor grills 40B controls the floor grills 40B such that the cooling air is blown in the left direction to supply the cooling air to the racks of the left row. Then, after the lapse of four minutes, the opening control unit 50B controls the floor grills 40B such that the cooling air is blown in the right direction to supply the cooling air to the racks of the right row. Thereafter, the opening control unit 50B repeats the process of changing, every four minutes, the blow-off direction of the floor grills 40B between the left and right directions.

Further, for example, as illustrated in FIG. 20, the opening control unit 50C for controlling the floor grills 40C performs a control to open the floor grills 40C on the left side and close the floor grills 40C on the right side to supply the cooling air to the racks of the left row. Then, after the lapse of four minutes, the opening control unit 50C performs a control to open the floor grills 40C on the right side and close the floor grills 40C on the left side. Thereafter, the opening control unit 50C repeats the process of opening and closing, every four minutes, the floor grills 40C on the left side and the floor grills 40C on the right side.

As described above, according to the fourth embodiment, the cooling air is alternately supplied to the racks of the left row and the racks of the right row facing the aisle supplied with the cooling air. It is therefore possible to change, every specified time, the position of the region supplied with the cooling air, and thereby to efficiently cool the racks 30 and eliminate the hot spot.

Fifth Embodiment

Further, in the above-described second embodiment, description has been made of an example in which the floor grills are opened and closed in block units each formed by a group of two adjacent floor grills. The present embodiment, however, is not limited thereto, and the floor grills may be opened and closed in aisle units corresponding to the aisles between the rack rows.

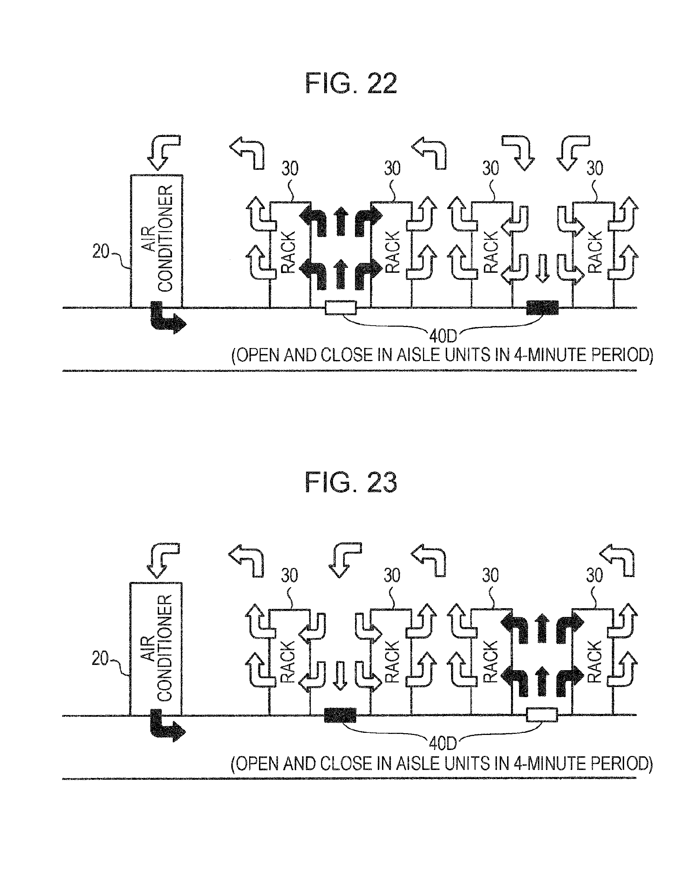

In the following fifth embodiment, therefore, an opening control process by an air conditioning system of the fifth embodiment is described, with reference to FIGs. 21 to 23, as an example of opening and closing the floor grills in aisle units. FIG. 21 is a diagram for explaining cooling air supplied when the floor grills are constantly open. FIG. 22 is a diagram for explaining cooling air supplied when the floor grills on the left half side are open. FIG. 23 is a diagram for explaining cooling air supplied when the floor grills on the right half side are open.

With reference to FIG. 21, description is first made of an existing air conditioning system which constantly opens all floor grills. It is assumed in the air conditioning system exemplified in FIG. 21 that the cooling air volume of the air conditioner 20 is 50% of the total indispensable air volume of the racks 30. The cooling air volume is insufficient with respect to the total indispensable air volume of the racks 30. As illustrated in FIG. 21, therefore, if the floor grills are constantly open, the cooling air fails to reach upper portions of the racks 30, and the IT devices mounted on upper shelves of the racks 30 constantly have a high intake air temperature.

The air conditioner 20 according to the fifth embodiment, therefore, opens and closes the floor grills in aisle units to change the aisles supplied with the cooling air, to thereby allow the cooling air to be supplied to the IT devices mounted on the upper shelves of the racks 30 and the IT devices mounted on the lower shelves of the racks 30.

Herein, the air conditioner 20 according to the fifth embodiment is described with reference to FIGs. 22 and 23. As the example of FIGs. 22 and 23, description is made of an example in which the cooling air volume of the air conditioner 20 is 50% of the total indispensable air volume of the racks 30 and the grill opening and closing time interval is "four minutes." Although not illustrated in FIGs. 22 and 23, floor grills 40D are connected to an opening control unit 50D in a similar manner as in the second embodiment.

As illustrated in FIG. 22, the opening control unit 50D for controlling the floor grills 40D performs a control to open only the floor grills 40D installed on the left aisle and close the floor grills 40D installed on the right aisle. Then, after the lapse of four minutes, the opening control unit 50D performs a control to open only the floor grills 40D installed on the right aisle and close the floor grills 40D installed on the left aisle, as illustrated in FIG. 23. Thereafter, the opening control unit 50D repeats the process of controlling, every four minutes, the opening and closing of the floor grills 40D installed on the left and right aisles.

As described above, according to the fifth embodiment, the floor grills 40D are opened and closed in aisle units corresponding to the aisles between the rack rows. It is therefore possible to change, every specified time, the position of the region supplied with the cooling air, and thereby to efficiently cool the racks 30 and eliminate the hot spot.

Sixth Embodiment

Description has been made above of the first and fifth embodiments of the present embodiment. The present embodiment, however, may be implemented by a variety of different embodiments other than the above-described embodiments. In the following, therefore, another embodiment is described as a sixth embodiment.

(1) System Configuration and Others

The constituent components of the devices illustrated in the drawings are functionally conceptual, and are not necessarily needed to be physically configured as illustrated in the drawings. That is, specific forms of distribution and integration of the devices are not limited to those illustrated in the drawings. Thus, all or a part of the devices can be functionally or physically distributed or integrated in arbitrary units in accordance with various loads, states of use, and so forth. For example, the motor control unit 51 and the opening and closing time setting and display unit 52 may be integrated.

Further, the process procedures, control procedures, specific names, and information including a variety of data and parameters illustrated in the above description or the drawings may be arbitrarily changed, unless otherwise specified. For example, the time interval for opening and closing the floor grills may be arbitrarily changed.
In any of the above aspects, the various features may be implemented in hardware, or as software modules running on one or more processors. Features of one aspect may be applied to any of the other aspects.
The invention also provides a computer program or a computer program product for carrying out any of the methods described herein, and a computer readable medium having stored thereon a program for carrying out any of the methods described herein. A computer program embodying the invention may be stored on a computer-readable medium, or it could, for example, be in the form of a signal such as a downloadable data signal provided from an Internet website, or it could be in any other form.

## Claims

1. An air conditioning system comprising:
an air conditioner configured to send cooling air to a space installed with racks for mounting one or more electronic devices, each of the electronic devices taking in air from a predetermined surface thereof and discharges air from a surface thereof opposite to the predetermined surface;
an opening panel configured to supply into the space the cooling air sent by the air conditioner; and
an opening control unit configured to control the opening panel to shift, every predetermined time, a position of a region in the space supplied with the cooling air.

2. The air conditioning system according to Claim 1, wherein the opening control unit controls opening and closing of the opening panel to shift, every the predetermined time, the position of the region supplied with the cooling air.

3. The air conditioning system according to Claim 1 or 2, wherein the opening control unit controls a blow-off direction of the opening panel to shift, every the predetermined time, the position of the region supplied with the cooling air.

4. The air conditioning system according to any of Claims 1 to 3, wherein the opening control unit controls the opening panel to shift, every time less than the time taken for an exhaust air temperature of the electronic devices to rise to a predetermined temperature, the position of the region supplied with the cooling air.

5. An air conditioning control method performed by an air conditioning control system having an air conditioner configured to send cooling air to a space installed with racks for mounting one or more electronic devices, each of the electric devices taking in air from a predetermined surface thereof and discharges air from a surface thereof opposite to the predetermined surface, an opening panel configured to supply into the space the cooling air sent by the air conditioner, and an opening control unit configured to control the opening panel, the air conditioning control method comprising:
controlling the opening panel to shift by the opening control unit, every predetermined time, a position of a region in the space supplied with the cooling air.

6. The method for air conditioning control according to claim 5, further controlling the opening panel to shift by the opening control unit, every predetermined time, an amount of the cooling air supply to the region in the space.

7. A computer program which, when executed by a processor of an air conditioning control system, causes the air conditioning control system to carry out an air conditioning control method as claimed in claim 5 or 6.
